## Europäisches Patentamt
## European Patent Office
## Office européen des brevets

(19)

(11) Publication number: **0 023 210**
**B1**

(12) **EUROPEAN PATENT SPECIFICATION**

(45) Date of publication of patent specification: **30.03.83**

(21) Application number: **80900215.7**

(22) Date of filing: **02.01.80**

(86) International application number:
**PCT/US80/00002**

(87) International publication number:
**WO 80/01528 24.07.80 Gazette 80/17**

(51) Int. Cl.³: **H 03 K 19/094,**
**H 03 K 19/017,**
**H 03 K 19/20,**
**H 03 K 17/693**

(54) **TRI-STATE LOGIC BUFFER CIRCUIT.**

(30) Priority: **11.01.79 US 2741**

(43) Date of publication of application:
**04.02.81 Bulletin 81/5**

(45) Publication of the grant of the patent:
**30.03.83 Bulletin 83/13**

(84) Designated Contracting States:
**DE FR GB NL**

(56) References cited:
**US - A - 3 832 574**
**US - A - 3 937 983**
**US - A - 3 980 898**
**US - A - 4 037 114**
**US - A - 4 042 839**
**US - A - 4 096 398**
**US - A - 4 135 102**

**IBM Technical Disclosure Bulletin Published MAY 1977, Vol. 19, No. 12, page 4673, see Figure, Love.**

(73) Proprietor: **Western Electric Company, Incorporated**
**222 Broadway**
**New York New York 10038 (US)**

(72) Inventor: **KELLER, Jack Kratzer**
**314 East Main Street**
**Macungie, PA 18062 (US)**
Inventor: **MOWERY, Gilbert Leroy, Jr.**
**4346 Clearview Circle**
**Allentown, PA 18103 (US)**

(74) Representative: **Lawrence, Brian Richard**
**Western Electric Company Limited 5, Mornington Road**
**Woodford Green Essex IG8 OTU (GB)**

**IBM Technical Disclosure Bulletin Published AUGUST 1975, Vol. 18, No. 3, pages 910— 911, Homan.**

# 0 023 210

## Tri-state logic buffer circuit

This invention relates to tri-state logic buffer circuits.

As known in the art, in many logic circuit applications, including those which are not controlled by a master timing clock ("asynchronous"), it is desirable to operate with three-state ("tri-state") capability. More specifically, it is desirable to have a number of separate buffer circuits each connecting a different one of a number of separate binary digital local input signal sources to a common data bus line. Each such buffer circuit has an output terminal connected to said common bus line, in order to deliver the corresponding digital local input signal to this common bus line if, and only if, no other signal is then actively present on that line from other sources; and otherwise to float (i.e., to present a very high impedance of the common data bus line).

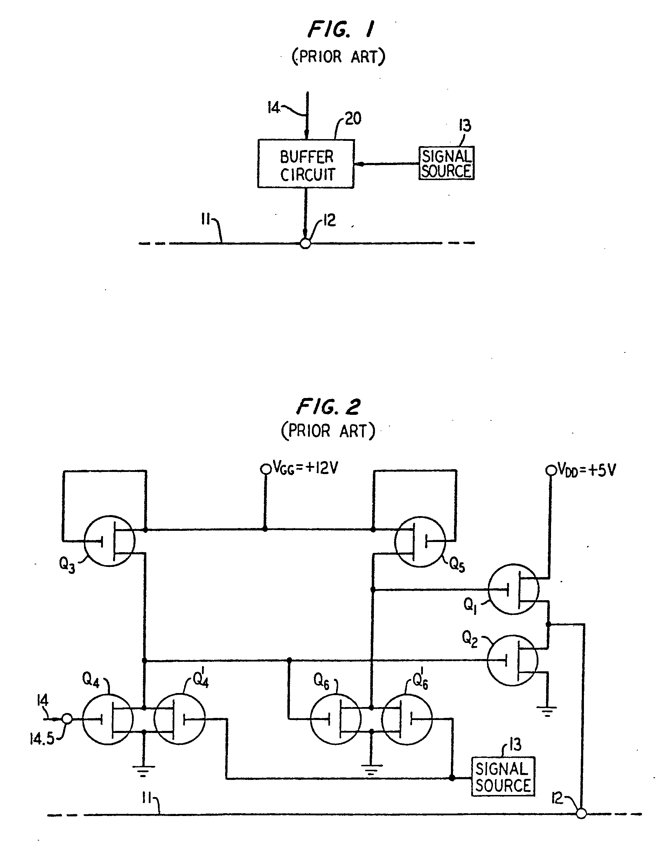

For purpose of illustrating these concepts and with reference to Fig. 1 of the accompanying drawings, a binary digital "1" or "0" signal ("high" or "low" voltage) may or may not actively be present from other sources (not shown) on a common data bus line 11 at a given moment. By a signal "actively" present from other sources on the common data bus line is meant a low impedance driven signal from another source. In the absence of any such active signal from other sources, the common data bus line 11 is electrically "floating"; that is to say, it has a very high impedance to ground. Only if this common data bus line 11 is "floating" can a buffer circuit 20 be enabled by a control signal from the source 13 to allow passage of a local binary digital input signal 14 to an output terminal 12 on the bus line 11. If there is a signal already actively present on the common data bus line 11, then the control signal source 13 prevents the buffer circuit 20 from passing any local signal 14 to the common data bus line 11. This causes the buffer circuit to present a very high impedance to the bus line; that is, the output of the buffer circuit 20 at terminal 12 is electrically in the "floating" state. Terminal 12 thus serves as a local signal output terminal of the buffer circuit 20. Since the local input signal 14 itself can be a "high" voltage (digital "1") or a "low" voltage (digital "0"), there are three possible local outputs or "states" ("1", "0", "float") of the buffer circuit 20 at its output terminal 12, depending upon the states of both the local signal input 14 and the control signal delivered by the source 13, all in accordance with the following:

| Local signal 14 | Control signal 13 | Non-inverting buffer circuit output |
|:---:|:---:|:---:|
| 0 | 1 | float |
| 1 | 1 | float |
| 0 | 0 | 0 |
| 1 | 0 | 1 |

In the prior art, such a tri-state buffer circuit has been proposed in the form of an MOS integrated circuit, in N-MOS technology for example (Fig. 2). Basically such a circuit includes a pair of MOS NOR-gates (formed by transistors $Q_3$, $Q_4$, $Q_4'$; $Q_5$, $Q_3$, $Q_6'$) feeding an MOS output load device including an output "driver" transistor $Q_2$ and an output load transistor $Q_1$. It should be understood that each of the transistors $Q_4$ and $Q_6$ is a high transconductance transistor serving as a driver and is substantially identical to its corresponding parallel connected twin transistor $Q_4'$ and $Q_6'$, respectively. The transistors $Q_3$ and $Q_5$ are relatively low transconductance transistors serving as load elements. The gate electrode of each of the transistors $Q_3$ and $Q_5$ is connected to the drain terminal of the respective transistor when using such enhancement mode N-MOS devices.

All transistors in the circuit shown in Fig. 2 are enhancement mode transistors, with the same threshold of typically about 1.2 volts. However, such a circuit requires both a relatively high voltage supply ($V_{GG}=+12$ volts) in addition to a relatively low voltage supply ($V_{DD}=+5$ volts) for reliable operation, because the inherent threshold voltage of the output load transistor $Q_1$ produces a "back-gate bias" of $Q_1$ itself when it is in the "on" condition. This "back-gate bias" arises because the voltage at the source of $Q_1$ becomes higher than the voltage of its substrate (ground), thereby increasing the required gate electrode voltage for turning this transistor "on", i.e., thereby increasing its threshold voltage during operation. This increase in threshold voltage during operation ("back-gate bias effect") prevents $Q_1$ from being turned "on" properly unless the drains and gates of NOR-gate load transistors ($Q_5$, $Q_3$) of the previous stages are connected to a relatively high voltage supply, typically +12 volts.

Specifically, when the output drive transistor $Q_2$ is "off" and the output load transistor $Q_1$ is "on", then the potential of the output terminal 12 tends towards $V_{DD}$, thereby undesirably tending to shut "off" this output load transistor $Q_1$ by virtue of the back-gate bias effect on its threshold, unless the voltage applied to its gate electrode is increased above $V_{DD}$ by a higher drain voltage supply ($V_{GG}=12$ volts) to $Q_5$. For example, if the threshold of $Q_1$ is 1.2 volts under the condition of zero "back-gate bias", i.e., when the source of $Q_1$ is at the same ("ground") potential as that of the semiconductor substrate,

2

then this threshold will rise to as much as about 3 volts when the source of $Q_1$ is at a potential of 4 or 5 volts, i.e., when $Q_1$ itself is "on". Accordingly, since the load transistor $Q_5$, which is then also "on", suffers from this same back-gate bias threshold effect, the source potential of $Q_5$ will not rise to the required voltage of about 3 volts necessary to keep $Q_1$ "on" unless the drain of $Q_5$ be supplied at considerably more than 5 volts, or unless $Q_5$ is a depletion mode N-MOS transistor with its gate electrode connected to its source. But even if $Q_5$ is a depletion mode device which supplies 5 volts to the gate of $Q_1$, the source of the output load transistor $Q_1$ when $Q_1$ is on will not be able to rise to much above 2 (=5—3) volts, instead of a desired 3 or more volts. The $Q_1$ source voltage can be increased to 3 or more volts if the supply to the drain of $Q_1$ and to the drain (and gate) of Q5 is raised to say 12 volts. Such a high voltage supply requires an additional voltage supply (i.e., +12 volts as well as +5 volts), and also results in undesirable power dissipation during operation. Accordingly, it would be desirable to have a tri-state logic buffer circuit which does not suffer from these problems.

In U.S. Patent No. 4,096,398 there is disclosed a tri-state logic buffer circuit comprising a first MOS transistor, a second MOS transistor whose source-drain path is electrically connected in series with the source-drain path of the first transistor, and a third MOS transistor one of whose high current carrying terminals is electrically connected to the gate electrode of the first transistor, one of the high current carrying terminals of the first and third MOS transistors being connected to a common terminal for the application thereto of a voltage supply. This disclosed circuit makes use of both enhancement and depletion type transistors but requires the use to two power supplies.

In U.S. Patent No. 3,832,574 there is disclosed an insulated gate field effect transistor circuit of similar form using multiple (two) threshold technology as applied to two-state circuit operation.

In accordance with the present invention a tri-state logic buffer circuit as aforesaid is characterised in that the zero back-gate threshold voltage of the first transistor is intermediate the zero back-gate bias threshold voltages of the second and third transistors.

In this way, a single, relatively low voltage supply (typically about +5 volts in N-MOS technology) can be used to obtain a satisfactory output level.

The foregoing and other features of the invention will now be described, reference being made to the accompanying drawings, in which:

Fig. 1 is an electrical block diagram of a tri-state logic buffer circuit, useful for describing its operation in the prior art;

Fig. 2 is a circuit diagram of a prior art tri-state buffer circuit in MOS technology;

Fig. 3 is a circuit diagram of an MOS tri-state non-inverting buffer circuit in accordance with a specific embodiment of the invention; and

Fig. 4 is a circuit diagram of an MOS tri-state inverting buffer circuit in accordance with another specific embodiment of the invention.

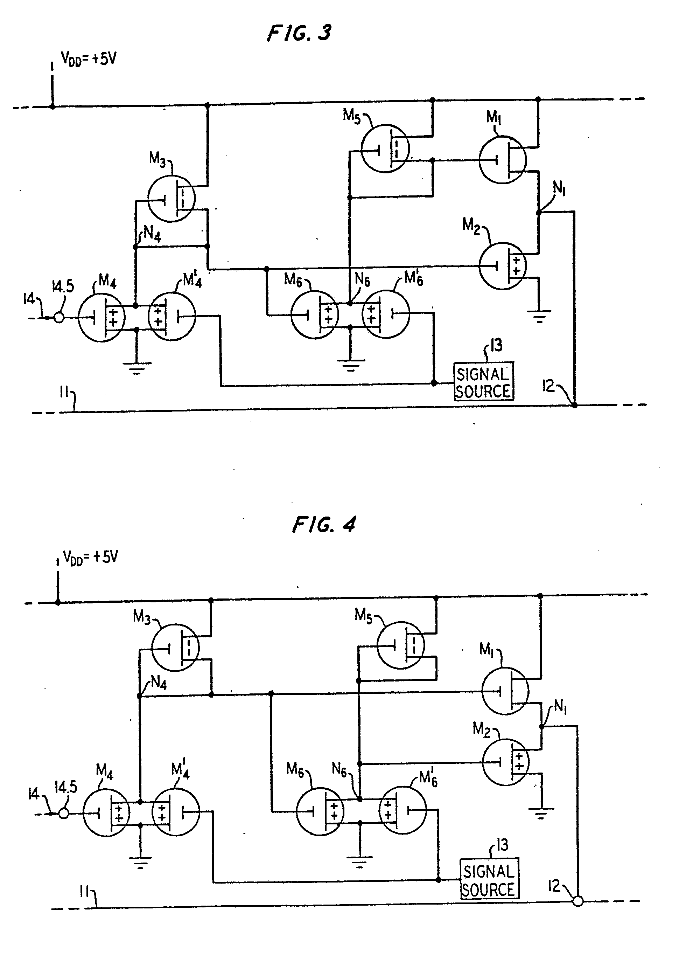

Transistors in Figs. 3 and 4 (N-MOS technology) that have channel regions doped with acceptor impurities (enhancement mode) are so indicated by the "plus" signs along the corresponding transistor channels in the drawing; on the other hand, transistors that have channel regions doped with donor impurities (depletion mode) are so indicated by "minus" signs along the corresponding transistor channels in the drawing and transistors with channels that are non-doped are so indicated by the lack of either such "plus" or "minus" signs along the corresponding channels. By "non-doped" is meant either that the channel is not subjected to impurity introduction beyond those impurities originally present in the semiconductor wafer or that the channel is doped only lightly as compared with the doping of the channel of an enhancement or depletion mode transistor.

Only for the sake of definitions, the buffer circuit illustrated in Fig. 3 is assumed to be in N-MOS technology. As shown in Fig. 3, a signal source 13 is connected to the gate electrodes of both the transistors $M_4'$ and $M_6'$. A local input signal terminal 14.5 is connected to the gate electrode of transistor $M_4$ whose high current (source-drain) path is in parallel with that of $M_4'$. The gate electrode of transistor $M_6$ is connected to the common drain node $N_4$ of transistors $M_4$ and $M_4'$. This common drain node $N_4$ is connected through the high current (source-drain) path of transistor $M_3$ to a voltage source $V_{DD}$ of typically +5 volts. Similarly, the common drain node $N_6$ of transistors $M_6$ and $M_6'$ is connected through the high current path of transistor $M_5$ to the voltage source $V_{DD}$. The gate electrode of each of the transistors $M_3$ and $M_5$ is connected to the respective source terminal of each of these transistors. Finally, the gate electrode of transistor $M_1$ is connected to the node $N_6$; the gate electrode of transistor $M_2$ is connected to the node $N_4$; and the high-current paths of $M_1$ and $M_2$ are mutually connected in series, the resulting common node $N_1$ between $M_1$ and $M_2$ being connected to the output terminal 12 on the common data bus line 11. The transistor $M_1$ serves as a "load" during operation and the transistor $M_2$ serves as the "driver" of said "load". Typical values of the parameters of transconductance $\beta$ and threshold voltage $V_T$ (under zero back-gate bias) are:

| Transistor | $\beta$ ($10^{-6}$ amps/volt$^2$) | $V_T$ (volts) |
|---|---|---|
| $M_1$ (non-doped channel) | 400 | 0.1 |
| $M_2$ (enhancement) | 2200 | 1.2 |
| $M_3$ (depletion) | 50 | —4.5 |

| Transistor | $\beta(10^{-6}$ amps/volt$^2)$ | $V_T$ (volts) |
|---|---|---|
| $M_4$ (enhancement) | 600 | 1.2 |
| $M_5$ (depletion) | 50 | −4.5 |
| $M_6$ (enhancement) | 600 | 1.2 |

As seen from the above listing of parameters, the transconductance $\beta$ of the output driver transistor $M_2$ is higher than that of the output load transistor $M_1$, but this may not be essential. The respective values of transconductance $\beta$ are achieved by suitable choices of the ratio of channel width to length, as known in the art; the respective values of threshold voltage $V_T$ are obtained by suitable impurity doping of the semiconductor gate regions of the respective channels, as by ion implantation techniques known in the art. This channel impurity doping can, for example, be achieved by using known masking techniques with apertures over those gate regions where the impurity is desired to be implanted during an ion-implantation step, so that only those transistors with channels underlying unmasked (apertured) gate regions will have their thresholds altered by the implantation step.

In order to understand the operation of the circuit shown in Fig. 3, first consider the case where the control signal 13 is "high" in voltage level (digital "1") due to the presence of a "1" or a "0" signal level on the common data bus line 11 actively present from another local signal source. In this case, this control signal puts both the high $\beta$ transistors $M_4'$ and $M_6'$ into their "on" conditions, thereby bringing both the nodes $N_4$ and $N_6$ to ground potential, i.e., "low" potential. This puts both the transistors $M_1$ and $M_2$ into their "off" conditions, regardless of the conditions of the low $\beta$ transistors $M_3$ and $M_5$ in series therewith, and regardless of the conditions of the transistors $M_4$ and $M_6$ in parallel therewith. Accordingly, the node $N_1$ then is controlled solely by the voltage on line 11, regardless of the local input signal 14, i.e., regardless of the "on" or "off" conditions of $M_4$ and $M_6$. Thus, a control signal 13 which is "high" prevents the passage of local signal 14 to the common data bus line 11, as desired.

Turning to the case where the control signal 13 is "low", i.e., all other local signal sources (buffers) connected to line 11 are "floating" (outputs are in high impedance state); in this case both of the transistors $M_4'$ and $M_6'$ are thus "off". Accordingly the voltages at nodes $N_4$ and $N_6$, and hence the voltage on the gate electrodes of $M_1$ and $M_2$, respectively, depend upon the "on" or "off" conditions of transistors $M_4$ and $M_6$.

If the local input signal 14 is then "high" (digital "1"), then the high $\beta$ transistor $M_4$ is "on", thereby bringing the potential of node $N_4$ down to substantially ground ("low") potential and hence putting both the transistors $M_2$ and $M_6$ into their respective "off" conditions. On the other hand, the potential of the node $N_6$ will then be controlled by the condition of transistor $M_5$, since then both transistors $M_6$ and $M_6'$ are "off". At this time the potential of node $N_6$ will thus be about +5 volts since the threshold voltage of transistors $M_5$ is so negative even in the presence of the increase in threshold to typically about −2 or −3 volts, caused by the resulting back-gate bias, instead of the −4.5 volts under zero back-gate bias. Accordingly, the node $N_6$ being at +5 volts, the output load transistor $M_1$ will be "on", and very strongly so, because its threshold is only a fraction of a volt under zero back-gate bias and is less than +2 volt (and hence much less than +5 volt) under a back-gate bias of as much as 4 or 5 volts. Thus, the potential of $N_1$ and hence of the source of the output load transistor $M_1$, and hence also the output voltage at the output terminal 12, will then rise to at least about (5−2)=3 volts. On the other hand, with a 1.2 volt threshold for this output load transistor under zero back-gate bias, this output voltage would be only about 2 volts or less. Accordingly, the advantage of using a relatively low (i.e., lower than that of $M_2$) but positive threshold voltage for the output load transistor $M_1$ is apparent: it provides a wider margin of distinction in output voltage level between an output "0" (= volts) and an output "1" (=3 volts or more).

Consider next the case where the control signal 13 is still "low" (no signals on the line 11 from other sources) and the local signal 14 is also "low" (digital "0"); then, since both transistors $M_4$ and $M_4'$ are "off", the node $N_4$ will be at a voltage about equal to $V_{DD}$=5 volts. Accordingly, both the NOR-gate driver transistor $M_6$ and the output driver $M_2$ will be "on"; so that in particular the node $N_6$ will be substantially at ground potential, thereby keeping the output load transistor $M_1$ in its "off" condition, while the output driver transistor $M_2$ will then be "on". Thus, the output terminal 12 will be at ground ("low") potential, that is, an output digital "0" results in response to a local input signal 14 of digital "0", as desired.

Turning to the tri-state MOS buffer circuit shown in Fig. 4, this buffer circuit is obtained by modifying the circuit of Fig. 3 to connect the node $N_4$ to the gate electrode of transistor $M_1$ instead of $M_2$ and the node $N_6$ to the gate electrode of $M_2$ instead of $M_1$. In this way, when the control signal does not disable the buffer circuits, a local input signal at input terminal 14.5 of digital "1" results in an inverted output voltage at the output terminal 12, or a digital "0" (instead of digital "1" as in the buffer circuit of Fig. 3), and a local input of digital "0" results in an output of digital "1". Thus, the buffer circuit of Fig. 4 inverts the local input signal so long as the control signal source 13 does not put out its disabling signal, otherwise (when the control signal is disabling) the output of this buffer circuit is electrically "floating" just as in the case of the circuit shown in Fig. 3.

It should be noted that the arrangement of transistors $M_3$, $M_4$ and $M_4'$ constitutes a NOR-gate, as does the arrangement of transistors $M_5$, $M_6$, and $M_6'$. Specifically, the node $N_4$ is "high" in voltage only if

4

both transistors $M_4$ and $M_4'$ are "off", that is, only if neither the local input signal 14 nor the control signal from the control signal source 13 is "high". If either such signal is "high", then the corresponding transistor $M_4$ or $M_4'$ is "on", thereby connecting the node $N_4$ to ground ("low") potential through a high $\beta$ (high conductance) path. Conversely, the only way that the node $N_4$ can be "high" (digital "1") is by having both transistors $M_4$ and $M_4'$ in the "off" condition, that is, by having the voltage of both the input signals 13 and 14 "low" (digital "0"). Thus, the output at node $N_4$ of the arrangement $M_3$, $M_4$, and $M_4'$ corresponds to that of a NOR-gate; and similarly for the arrangement $M_5$, $M_6$, and $M_6'$.

As noted above, it is advantageous that the threshold voltage of the output load transistor $M_1$ be lower than those of the output driver transistor $M_2$ and the NOR-gate driver transistors ($M_4$, $M_4'$, $M_6$, $M_6'$), in order to promote wider margin of output level distinction between the "on" and "off" conditions of $M_1$. On the other hand, it is also advantageous that the threshold voltages of the load transistors $M_3$ and $M_5$ in the NOR-gates be still lower than that of the load transistor $M_1$ in the output, in order to avoid undesirable threshold drops across these NOR-gate loads even under operating conditions of back-gate bias which would otherwise prevent proper turn-on of the output load transistor $M_1$. Thus, the threshold voltage of the output load transistor $M_1$ should be intermediate between that of the NOR-gate load transistors ($M_5$ and $M_3$) and that of the NOR-gate drive transistors ($M_4$, $M_4'$, $M_6$, $M_6'$).

Although this invention has been described in detail in terms of specific illustrations, various modifications can be made without departing from the scope of the invention. For example, the output load transistor can have non-vanishing impurity doping (as by ion implantation) in its gate (channel) region in conjunction with a suitable semiconductor wafer substrate doping level, in order to obtain substantially the same threshold voltage as in the case of the undoped channel region. Also regarding technology, instead of N-MOS transistors, P-MOS (P channel) transistors can be used by changing the polarity of the voltage supply and correspondingly changing the threshold voltages of the various transistors by suitable impurity doping.

## Claims

1. A tri-state logic buffer circuit comprising a first MOS transistor ($M_1$), a second MOS transistor ($M_2$) whose source-drain path is electrically connected in series with the source-drain path of the first transistor, and a third MOS transistor ($M_3$, Fig. 4; $M_5$, Fig. 3) one of whose high current carrying terminals is electrically connected to the gate electrode of the first transistor ($M_1$), one of the high current carrying terminals of the first and third MOS transistors being connected to a common terminal for the application thereto of a voltage supply ($V_{DD}$), characterized in that the zero back-gate threshold voltage of the first transistor ($M_1$) is intermediate the zero back-gate bias threshold voltages of the second and third transistors ($M_2$, $M_3$).

2. A circuit as claimed in claim 1, comprising a fourth MOS transistor ($M_4$, Fig. 4; $M_6$, Fig. 3) one of whose high current carrying terminals is electrically connected to the said gate electrode of the first transistor ($M_1$), and a fifth transistor ($M_5$, Fig. 4; $M_3$, Fig. 3) one of whose high current carrying terminals is electrically connected to the said gate electrode of the second transistor ($M_2$), the said threshold voltage of the first transistor being intermediate that of the fourth transistor and that of the third transistor.

3. A circuit as claimed in claim 2, comprising a sixth MOS transistor ($M_6$, Fig. 4; $M_4$, Fig. 3) one of whose high current carrying terminals is electrically connected to the gate electrode of the second transistor ($M_2$), the said threshold voltage of the first transistor being intermediate that of the sixth transistor and that of the fifth transistor.

4. A circuit as claimed in any preceding claim, in which the transconductance of the first transistor ($M_1$) is lower than that of the second transistor ($M_2$).

5. A circuit as claimed in any preceding claim, in which the transconductance of said fourth transistor is higher than that of said third transistor.

6. A circuit as claimed in any preceding claim, in which the transconductance of the sixth transistor is higher than that of the fifth transistor.

7. A circuit as claimed in claim 2, in which one high current carrying terminal of fifth MOS transistor is connected to said common terminal.

## Patentansprüche

1. Tristate-Logikpufferschaltung mit einem ersten MOS-Transistor ($M_1$), einem zweiten MOS-Transistor ($M_2$), dessen Source-Drain-Strecke elektrisch in Reihe mit der Source-Drain-Strecke des ersten Transistors geschaltet ist, und mit einem dritten MOS-Transistor ($M_3$, Fig. 4; $M_5$, Fig. 3), von dem einer seiner hohen Strom führenden Aschlüsse elektrisch mit der Gate-Elektrode des ersten Transistors ($M_1$) verbunden ist, wobei einer der hohen Strom führenden Anschlüsse des ersten und dritten MOS-Transistors mit einem gemeinsamen Anschluß zur Anschaltung einer Spannungsquelle ($V_{DD}$) verbunden ist, dadurch gekennzeichnet, daß die Schwellenwertspannung des ersten Transistors ($M_1$) für eine Gate-Rückvorspannung Null zwischen den Schwellenwertspannungen des zweiten und dritten Transistors ($M_2$, $M_3$) für eine Gate-Rückvorspannung Null liegt.

2. Schaltung nach Anspruch 1 mit einem vierten MOS-Transistor ($M_4$, Fig. 4; $M_6$, Fig. 3), bei dem einer seiner hohen Strom führenden Anschlüsse elektrisch mit der Gate-Elektrode des ersten Transistors ($M_1$) verbunden ist, und mit einem fünften Transistor ($M_5$, Fig. 4; $M_3$, Fig. 3), bei dem einer seiner hohen Strom führenden Anschlüsse elektrisch mit der Gate-Elektrode des zweiten Transistors ($M_2$) verbunden ist, wobei die Schwellenwertspannung des ersten Transistors zwischen der des vierten und des dritten Transistors liegt.

3. Schaltung nach Anspruch 2 mit einem sechsten MOS-Transistor ($M_6$, Fig. 4; $M_4$, Fig. 3), bei dem einer seiner hohen Strom führenden Anschlüsse elektrisch mit der Gate-Elektrode des zweiten Transistors ($M_2$) verbunden ist, wobei die Schwellenwertspannung des ersten Transistors zwischen der des sechsten und des fünften Transistors liegt.

4. Schaltung nach einem der vorhergehenden Ansprüche, bei der die Transkonduktanz des ersten Transistors ($M_1$) niedriger als die des zweiten Transistors ($M_2$) ist.

5. Schaltung nach einem der vorhergehenden Ansprüche, bei der die Transkonduktanz des vierten Transistors höher als die des dritten Transistors ist.

6. Schaltung nach einem der vorhergehenden Ansprüche, bei der die Transkonduktanz des sechsten Transistors höher als die des fünften Transistors ist.

7. Schaltung nach Anspruch 2, bei der ein hohen Strom führender Anschluß des fünften MOS-Transistors mit dem gemeinsamen Anschluß verbunden ist.

**Revendications**

1. Un circuit logique séparateur à trois états comprenant un premier transistor MOS ($M_1$), un second transistor MOS ($M_2$) dont le circuit source-drain est connecté électriquement en série avec le circuit source-drain du premier transistor, et un troisième transistor MOS ($M_3$, figure 4; $M_5$, figure 3) dont l'une des bornes d'acheminement de courant élevé est connectée électriquement à l'électrode de grille du premier transistor ($M_1$), l'une des bornes d'acheminement de courant élevé du premier et troisième transistors MOS étant connectée à une borne commune destinée à recevoir une tension d'alimentation ($V_{DD}$), caractérisé en ce que la tension de seuil dans les conditions de polarisation de grille arrière nulle du premier transistor ($M_1$) est intermédiaire entre les tensions de seuil dans les conditions de polarisation de grille arrière nulle des second et troisième transistors ($M_2$, $M_3$).

2. Un circuit tel que revendiqué dans la revendication 1, comprenant un quatrième transistor MOS ($M_4$, figure 4; $M_6$, figure 3) dont l'une des bornes d'acheminement de courant élevé est connectée électriquement à l'électrode de grille du premier transistor ($M_1$), et un cinquième transistor ($M_5$, figure 4; $M_3$, figure 3) dont l'une des bornes d'acheminement de courant élevé est connectée électriquement à l'électrode de grille du second transistor ($M_2$), la tension de seuil du premier transistor étant intermédiaire entre celle du quatrième transistor et celle du troisième transistor.

3. Un circuit tel que revendiqué dans la revendication 2, comprenant un sixième transistor MOS ($M_6$, figure 4; $M_4$, figure 3) dont l'une des bornes d'acheminement de courant élevé est connectée électriquement à l'électrode de grille du second transistor ($M_2$), la tension de seuil du premier transistor étant intermédiaire entre celle du sixième transistor et celle du cinquième transistor.

4. Un circuit tel que revendiqué dans n'importe quel revendication précédente, dans lequel la transconductance du premier transistor ($M_1$) est inférieure à celle du second transistor ($M_2$).

5. Un circuit tel que revendiqué, dans n'importe quelle revendication précédente, dans lequel la transconductance du quatrième transistor est supérieure à celle du troisième transistor.

6. Un circuit tel que revendiqué dans n'importe quelle revendication précédente, dans lequel la transconductance du sixième transistor est supérieure à celle du cinquième transistor.

7. Un circuit tel que revendiqué dans la revendication 2, dans lequel une borne d'acheminement de courant élevé du cinquième transistor MOS est connectée à la borne commune.

0 023 210

## FIG. 1
(PRIOR ART)

## FIG. 2
(PRIOR ART)

1

## FIG. 3

## FIG. 4